Europäisches Patentamt

European Patent Office

Office européen des brevets

(19)

(11) **EP 0 876 620 B1**

(12) **EUROPEAN PATENT SPECIFICATION**

(45) Date of publication and mention
of the grant of the patent:
**09.06.2004 Bulletin 2004/24**

(51) Int Cl.[7]: **G01R 31/08**, H02H 3/16

(86) International application number:
**PCT/FI1997/000599**

(21) Application number: **97942985.9**

(22) Date of filing: **03.10.1997**

(87) International publication number:
**WO 1998/020356 (14.05.1998 Gazette 1998/19)**

(54) **METHOD OF DETECTING AND LOCATING A HIGH-RESISTANCE EARTH FAULT IN AN ELECTRIC POWER NETWORK**

VERFAHREN ZUR ERFASSUNG UND ORTUNG VON HOCHOHMIGEN ERDSCHLÜSSEN IN EINEM STROMVERSORGUNGSNETZ

PROCEDE DE DETECTION ET DE LOCALISATION DE DEFAUT DE TERRE A RESISTANCE ELEVEE DANS UN RESEAU ELECTRIQUE

(84) Designated Contracting States:
**AT BE DE DK ES FR GB IE IT NL SE**

(30) Priority: **04.11.1996 FI 964431**

(43) Date of publication of application:
**11.11.1998 Bulletin 1998/46**

(73) Proprietor: **ABB Oy**
**00380 Helsinki (FI)**

(72) Inventor: **LEHTONEN, Matti**
**FIN-02200 Espoo (FI)**

(74) Representative: **Lipsanen, Jari Seppo Einari**
**Seppo Laine Oy,**
**Itämerenkatu 3 B**
**00180 Helsinki (FI)**

(56) References cited:
**WO-A-95/24014**          **DE-A- 4 140 556**
**US-A- 4 729 052**        **US-A- 5 390 067**
**US-A- 5 515 227**

EP 0 876 620 B1

## Description

The present invention relates to a method according to the preamble of claim 1 for detecting and locating a high-resistance line-to-earth fault in an electric power network.

Conventionally, the need for earth fault detection has been solved by monitoring the zero-sequence voltage (that is, the neutral-point voltage) of an electric power network. In this arrangement, a line-to-fault alarm is issued when the neutral-point voltage exceeds a preset limit.

In US Pat. No. 4,729,052, a method is disclosed based on detecting the line-to-earth fault through altering the earth system impedance connected to the neutral point of the power system and then measuring the effect of this change on the neutral-point voltage. Said method is applicable to compensated-neutral networks having a resonant compensating coil connected to the neutral point.

In DE Pat. No. 41 40 556 is disclosed an arrangement closest akin to the present invention. Said arrangement aims at detecting by relay protection means the faulted line under an earth fault condition. This operation is performed by comparing the neutral-point voltage in phasor format with one of the phase-to-phase voltages, one of the positive-sequence voltage components or any other reference voltage not affected by the earth fault. Hence, the application area of said arrangement is within conventional relay protection, where a strong trip criterium exists and the actual fault detection is based on the absolute value of the neutral-point voltage.

In conventional techniques, a problem has been the lack of a reliable, general-purpose and sufficiently sensitive detection method for fault resistances in the order of 20 kohm and above.

It is an object of the present invention to overcome the drawbacks of the above-described techniques and provide an entirely novel type of method for detecting and locating a high-resistance earth fault in an electric power network.

The goal of the invention is achieved by detecting the earth fault through comparing the zero-sequence voltage (neutral-point voltage) measured at a network substation to the positive-sequence component of a phase voltage measured from the network and to the resultant zero-sequence impedance of the network. The comparison is made in phasor format, that is, treating the voltages as zero-phase referenced vectors. The result of the comparison is a magnitude estimate of the fault resistance. The resultant zero-sequence impedance used in the comparison may be based on an approximate value obtained from network model computation. Hence, the invention draws upon the utilization of phase leg voltage measurements carried out in routine fashion at substations.

The major differences of the present invention with regard to conventional arrangements are the following:

- Comparison is performed in phasor format against both the positive-sequence voltage component of the phase leg suspected to be faulted and the resultant zero-sequence impedance of the network.

- The method indicates the faulted phase leg by comparing the fault impedances computed individually for all the phase legs of the three-phase system. In the faulted phase leg, the fault impedance is resistive, while in the other two phase legs the computed real part of the phase impedance is negative, which is an unrealistic situation.

- The method gives an estimate over the magnitude of the fault resistance, wherefrom the level of the fault current can be easily computed.

- The computed fault current may be compared to fault currents actually measured from the network, whereby a conforming criterium for fault detection as well as a more accurate location of the fault in the network can be obtained.

More specifically, the method according to the invention is characterized by what is stated in the characterizing part of claim 1.

The invention offers significant benefits.

By virtue of the invention, the conventional fault detection procedure based on monitoring the absolute value of the zero-sequence voltage is improved substantially, because now the neutral-point voltage is measured in phasor format and the occurrence of a resistive fault is assured by way of comparing the zero-sequence voltage thus obtained to the zero-sequence impedance of the network. Thus, the range of fault detection can be extended to essentially higher fault resistance values.

An advantage of the present invention over the technique of US Pat. No. 4,729,052 is that no additional components need be connected to the neutral point of the network that would directly form a part of the fault circuit in the network. Another benefit is that also earth faults in unearthed and resistor-earthed networks can now be detected.

The present invention differs from the technique of cited DE Pat. No. 41 40 556 therein that the neutral-point voltage is not only compared to a variable computed from one of the phase leg voltages, but additionally to the zero-sequence impedance of the network, and the phase angle criterium is not applied earlier than at this stage. It must be noted herein that the method disclosed in cited DE Pat. No. 41 40 556 is not either applicable to the detection of an earth fault occurring via a high earth fault resistance. In a compensated network with compensation-coil-earthed neutral point, cited method would give random results already at very low values of the earth fault resistance, because in such a network the phase angle of the zero-sequence impedance can vary in a very large range (covering almost 180°) depending on the tuning degree of the compensation coil.

The adoption of the novel method disclosed herein requires only the programming of some new procedures into the storage means of earth-fault monitoring system and patching of a simple network model program module to the software of the network supervisory/control system.

The novel method needs no new transducers, but instead, can utilize for the voltage measurement, e. g., at a substation the voltage transformer conventionally connected over two phase legs for serving the electric power supply of the substation.

In the following the invention is described in greater detail with the help of exemplifying embodiments by making reference to the appended drawings in which

Figure 1 shows schematically the equivalent circuit of a network circuit to be monitored by means of the method according to the invention;

Figure 2a shows the equivalent circuit of the zero-sequence impedance in an unearthed and in a resistor-earthed network; and

Figure 2b shows the equivalent circuit of the zero-sequence impedance in a network having the capacitive component of the earth-fault current entirely or partially compensated.

The method is applicable to the detection and location of earth faults of an electric power network occurring via a large fault resistance under such conditions where the sensitivity of conventional relay protection fails to detect the fault. The operating range of the method covers fault resistances in the order of 5-150 kohm.

Even though the method is principally directed for use in unearthed and compensating-coil-earthed networks, it is also functional in networks earthed via a high earth system resistance.

The method is based on the analysis of voltages measured at a substation. By way of measuring the neutral-point voltage of the electric power network in phasor format and then comparing the measured value to the positive-sequence component of each phase leg voltage, a high-resistance, single-phase earth fault within the protection zone of the (medium-voltage) substation feeding the network can be detected. Furthermore, in addition to a general alarm on an earth fault, the neutral-point voltage analysis indicates the magnitude of the fault resistance, the corresponding value of fault current and the phase leg affected by the earth fault.

Utilizing these data, the analysis is continued for the zero-sequence currents of the network and these are then compared to the voltage of faulted phase leg. The novel method differs from conventional earth fault protection and detection therein that now the earth-fault current is not compared to the neutral point voltage, but instead, to the positive-sequence component of each phase leg voltage; herein the fault impedance at the earth fault point is considered to be purely resistive.

By virtue of current measurements, the result of the zero sequence voltage analysis can be verified and more accurate data on the location of the fault is obtained. Suitable measurement points for network currents are the outgoing feeders of the substation as well as branching points along the transmission line and disconnecting/sectionalizing stations.

The zero-sequence analysis is based on solving the components of the equivalent circuit representing the earth-fault conditions. When the voltages and the resultant zero-sequence impedance are known, the impedance of the assumed fault can be obtained from the equation:

$$\underline{Z}_f = (\frac{\underline{U}_v}{\underline{U}_0}-1)\underline{Z}_0$$

where
$\underline{Z}_0$ is the zero-sequence impedance,
$\underline{Z}_f$ is the computed fault impedance,
$\underline{U}_v$ is the positive-sequence component of the phase voltage, and
$\underline{U}_0$ is the measured neutral-point voltage.

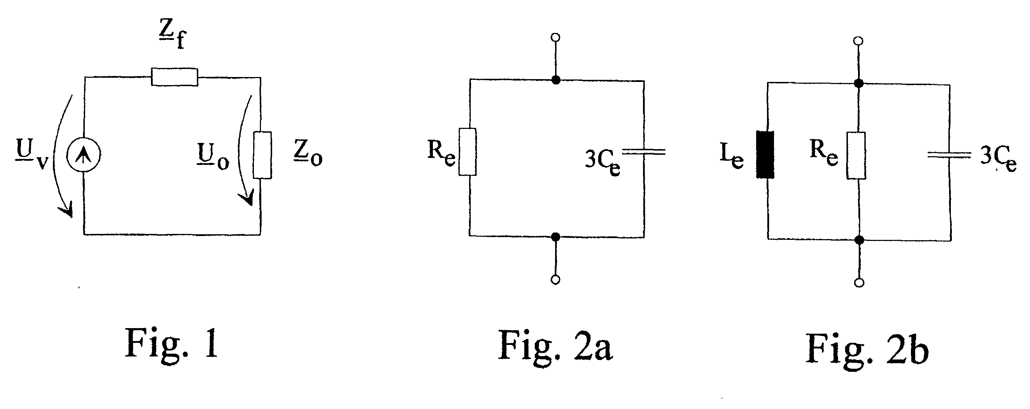

The zero-sequence impedance $\underline{Z}_0$ is computed by means of a network model simulating the electric power network from an equivalent circuit shown in Figs. 2a and 2b. An important parameter required for the model is the total line length of the electric power network and its earth capacitance over the area of the network. The latter parameter may vary according to the actual configuration of the network. In Fig. 2a is illustrated the equivalent circuit of the zero-sequence impedance $\underline{Z}_0$ in an unearthed or a resistor-earthed network, while Fig. 2b shows respectively the same parameters in a resonant-earthed or compensated network. In the case of the unearthed network shown in Fig. 2a, the dominating component of the equivalent circuit is the earth capacitance $C_e$ of the network. These elements have a leakage resistance component $R_e$ representing about 5-8% of the earth current (as computed from practical formula $R_e = 12.5\text{-}20 \cdot X_c$, where $X_c$ is the reactance of the earth capacitance $C_e$). In a resonant-earthed network, these circuit components will additionally have the reactance of the compensation coil $L_e$ in parallel as shown in Fig. 2b. The equivalent circuit of Fig. 2a is also valid for resistance-earthed networks, whereby the leakage resistance $R_e$ is reduced essentially.

The variables to be measured in the method are:

- three phase leg voltages at the substation, and

- the neutral-point current and one phase-to-phase voltage at all current measurement points.

The neutral-point voltage $\underline{U}_0$ is computed from the phase leg voltages as a phasor sum. Each phase leg voltage $\underline{U}_v$ is computed as the positive-sequence component of a symmetrical component system from the measurement values taken at the time instant under computation. To identify the faulted phase leg, the equation (1) is solved for three phasor directions:

1) $\underline{U}_v$ in its unrotated angle
2) $\underline{U}_v$ rotated by +120 electrical degrees
3) $\underline{U}_v$ rotated by +240 electrical degrees.

Each computation cycle gives an estimate for $\underline{Z}_f$. Of these, the faulted phase leg is selected to be the one giving the highest value for the real part of $\underline{Z}_f$. Because the fault impedance $\underline{Z}_f$ in practice is purely resistive, the computation for the two intact phase legs must necessarily give a negative real part of the fault impedance.

According to the current practice, an earth fault is considered detected with the provision that in the phase leg representing the largest value of the real part of $\underline{Z}_f$:

- the real part of $\underline{Z}_f$ is at least 4-fold as compared to the imaginary part of $\underline{Z}_f$.

This condition is equivalent to a criterium that the phase angle of the fault impedance is maximally ±15 electrical degrees. After the fault resistance is computed, the equivalent circuit of Fig. 1 can be used to solve the fault current and its phase angle, too.

Resulting, the zero-sequence voltage analysis yields the following information:

- indication of the faulted phase leg,

- magnitude estimate of fault resistance, and

- estimates for fault current and its phase angle.

If the fault resistance is high, its contribution to the network parameters may frequently be difficult due to the nonzero neutral-point voltage under normal conditions. Such a nonzero normal-state neutral-point voltage is chiefly caused by the capacitance asymmetry of the network and its value changes only infrequently. Hence, it is possible to increase the sensitivity of the disclosed method by replacing the real-time zero-sequence voltage measurement with a trend analysis based on monitoring a change value defined as the deviation of the real-time zero-sequence voltage value from its mean value computed over the latest 10 minutes, for instance. This approach elevates the earth fault indication sensitivity up to fault resistances of about 100-150 kohm. These quoted figures are based on field tests performed on unearthed networks.

After a general earth-fault alarm has been tripped by the zero-sequence voltage analysis program, the fault detection result can be verified and the closer site of the earth fault located by means of analyzing the zero-sequence current measurements. Herein, the zero-sequence currents measured at the substation and/or along the network are compared in phasor format with the zero-sequence current values obtained from the zero-sequence voltage analysis, and resultingly, the section of the network under analysis is considered to have an earth fault if:

- the measured magnitude of the zero-sequence current is, within a given margin, equal to the value computed according to above-described method, and
- the measured phase angle of the zero-sequence current is, within a given margin, equal to the value computed according to above-described method.

The allowable margin for phase angle can be the same as quoted above, tentatively ±15 electrical degrees. For the current, the allowable margin in the comparison may be relaxed, tentatively to about ±30 %.

In the same fashion as with the zero-sequence voltage analysis, the sensitivity of the method to high-resistance earth faults may be increased by replacing the real-time zero-sequence voltage measurements with a change-value variable computed as the deviation of the instantaneous zero-sequence voltage from its long-term mean value.

The basic concept of the invention is to compare the neutral point voltage $\underline{U}_0$ to the positive-sequence component $\underline{U}_v$ of each phase leg voltage and further to the resultant zero-sequence impedance $\underline{Z}_0$ of the network.

The method offers variability chiefly therein as which voltage criterium is used for fault detection instead of the positive-sequence component of each phase leg voltage. Suitable alternatives are:

1) Voltage of the faulted phase leg just prior to the occurrence of the fault

2) Positive-sequence voltage component of the faulted leg (during the fault)

3) Sum of the positive- and negative-sequence voltage components of the faulted phase leg (during the fault).

In addition to these alternatives, the real-time zero-sequence voltage measurement can be replaced by a trend analysis of the zero-sequence voltage deviation from its long-term mean value (computed over the latest 10 minutes, for instance). The positive- and negative-sequence components of each phase leg voltage as well as the zero-sequence voltages can be computed from the measured phase-to-neutral voltages by using the established and well-known theory of symmetrical components.

The zero-sequence impedance of the network can be computed approximately by means of a network model. When required, the network model may be calibrated for the earth capacitances $C_e$ and leakage resistances $R_e$ through earth fault tests using known fault resistance values.

## Claims

1. A method of detecting and locating a high-resistance earth fault of an electric power network, in which method at the substation is measured

    - the neutral point voltage ($\underline{U}_0$) in phasor format,

    **characterized in that**

    - the phase leg voltages of the network are measured in phasor format,

    - the zero-sequence voltage phasor representing the neutral point voltage ($\underline{U}_0$) is formed as the phasor sum of the measured phase leg voltages,

    - the zero-sequence impedance ($\underline{Z}_0$) is computed by means of a network model,

    - the zero-sequence voltage ($\underline{U}_0$) is compared in phasor format with the phasors of the network phase leg voltages ($\underline{U}_v$) and the resultant zero-sequence impedance ($\underline{Z}_0$) of the network, and

    - from these computed variables are derived the fault impedances ($\underline{Z}_f$) for each phase leg, whereby the faulted leg is identified as the leg having the greatest value of the real part of the fault impedance ($\underline{Z}_f$).

2. A method as defined in claim 1, **characterized in that** the zero-sequence voltage ($\underline{U}_0$) is compared in phasor format to the phasor-format positive component ($\underline{U}_v$) of each phase leg voltage and further to the resultant zero-sequence impedance ($\underline{Z}_0$) of the network.

3. A method as defined in claim 1, **characterized in that** the zero-sequence voltage ($\underline{U}_0$) is compared to the voltage ($\underline{U}_v$) of the faulted phase leg measured just prior to the occurrence of the fault and further to the resultant zero-sequence impedance ($\underline{Z}_0$) of the network.

4. A method as defined in claim 1, **characterized in that** the zero-sequence voltage ($\underline{U}_0$) is compared to the phasor sum ($\underline{U}_v$) of the positive- and negative-sequence voltage component of the faulted phase leg and further to the resultant zero-sequence impedance ($\underline{Z}_0$) of the network.

5. A method as defined in any of claims 1 - 4, **characterized in that** the real-time value of the zero-sequence voltage ($\underline{U}_0$) is replaced in the comparison by the difference of the real-time value and a long-term mean value, e.g., the mean values thereof computed over the latest 10 minutes.

## Patentansprüche

1. Verfahren zum Erfassen und Orten eines hochohmigen Erdschlusses eines elektrischen Stromnetzes, bei welchem Verfahren an einer Unterstation die

    - Neutralpunkt-Spannung ($\underline{U}_0$) im Phasor-Format gemessen wird,

    **dadurch gekennzeichnet, dass**

    - die Phasen-Aderspannungen des Netzwerkes im Phasor-Format gemessen werden,

    - der Null-Sequenz-Spannungs-Phasor, welcher die Neutralpunkt-Spannung ($\underline{U}_0$) repräsentiert, als die Phasor-Summe der gemessenen Phasen-Aderspannungen gebildet wird,

    - mittels eines Netzwerk-Modells die Null-Sequenz-Impedanz ($\underline{Z}_0$) berechnet wird,

    - die Null-Sequenz-Spannung ($\underline{U}_0$) im Phasor-Format mit den Phasoren der Netzwerk-Phasen-Aderspannungen ($\underline{U}_v$) und der resultierenden Null-Sequenz-Impedanz ($\underline{Z}_0$) verglichen wird, und

    - aus diesen berechneten Variablen die Fehler-Impedanzen ($\underline{Z}_f$) für jede Phasenader abgeleitet werden, wodurch die fehlerhafte Ader als diejenige Ader identifiziert wird, welche den größten Anteil des Realteils der Fehler-Impedanz ($\underline{Z}_f$) aufweist.

2. Verfahren gemäß Anspruch 1, **dadurch gekennzeichnet, dass** die Null-Sequenz-Spannung ($\underline{U}_0$) im Phasor-Format mit der im Phasor-Format positiven Komponente ($\underline{U}_v$) jeder Phasen-Aderspan-

nung, und darüberhinaus mit der resultierenden Null-Sequenz-Impedanz ($\underline{Z}_0$) des Netzwerkes verglichen wird.

**3.** Verfahren gemäß Anspruch 1, **dadurch gekennzeichnet, dass** die Null-Sequenz-Spannung ($\underline{U}_0$) mit der Spannung ($\underline{U}_v$) der fehlerhaften Phasen-Ader, welche gerade vor dem Auftreten des Fehlers gemessen worden war, und darüberhinaus mit der resultierenden Null-Sequenz-Impedanz ($\underline{Z}_0$) des Netzwerkes verglichen wird.

**4.** Verfahren gemäß Anspruch 1, **dadurch gekennzeichnet, dass** die Null-Sequenz-Spannung ($\underline{U}_0$) mit der Phasor-Summe ($\underline{U}_v$) der Positiv-Sequenz-Spannungskomponente und der Negativ-Sequenz-Spannungskomponente der Fehler-Phasen-Ader, und darüberhinaus mit der resultierenden Null-Sequenz-Impedanz ($\underline{Z}_0$) des Netzwerkes verglichen wird.

**5.** Verfahren gemäß einem der Ansprüche 1 bis 4, **dadurch gekennzeichnet, dass** der Echtzeit-Wert der Null-Sequenz-Spannung ($\underline{U}_0$) beim Vergleichen durch die Differenz des Echtzeit-Wertes und eines Langzeit-Mittelwertes, dessen Mittelwerte beispielsweise über die letzten 10 Minuten berechnet worden sind, ersetzt wird.

## Revendications

**1.** Procédé pour détecter et localiser un défaut de terre à résistance élevée dans un réseau électrique, procédé dans lequel il est mesuré à la sous-station:

- la tension au point neutre ($U_o$) en format de vecteur tournant,

  **caractérisé en ce que**:

- les tensions des branches de phase du réseau sont mesurées en format de vecteur tournant,
- le vecteur tournant de tension de séquence nulle représentant la tension au point neutre ($U_o$) est formé comme la somme des vecteurs tournants des tensions des branches de phase mesurées,
- l'impédance de séquence nulle ($Z_o$) est calculée au moyen d'un modèle de réseau,
- la tension de séquence nulle ($U_o$) est comparée en format de vecteur tournant avec les vecteurs tournants des tensions des branches de phase du réseau ($U_v$) et avec l'impédance de séquence nulle ($Z_o$) résultante du réseau, et
- à partir de ces variables calculées, l'impédance de défaut ($Z_f$) est calculée pour chaque branche de phase, la branche défaillante étant identifiée comme étant la branche qui présente la plus grande valeur de la partie réelle de l'impédance de défaut ($Z_f$).

**2.** Procédé selon la revendication 1, **caractérisé en ce que** la tension de séquence nulle ($U_o$) est comparée en format de vecteur tournant au composant positif en format de vecteur tournant ($U_v$) de chaque tension de branche de phase, ainsi qu'à l'impédance de séquence nulle résultante ($Z_o$) du réseau.

**3.** Procédé selon la revendication 1, **caractérisé en ce que** la tension de séquence nulle ($U_o$) est comparée à la tension ($U_v$) de la branche de phase défaillante mesurée juste avant la survenance du défaut, ainsi qu'à l'impédance de séquence nulle résultante ($Z_o$) du réseau.

**4.** Procédé selon la revendication 1, **caractérisé en ce que** la tension de séquence nulle ($U_o$) est comparée à la somme de vecteurs tournants ($U_v$) du composant de tension de séquence positif et négatif de la branche de phase défaillante, ainsi qu'à l'impédance de séquence nulle résultante ($Z_o$) du réseau.

**5.** Procédé selon l'une quelconque des revendications 1 à 4, **caractérisé en ce que** la valeur en temps réel de la tension de séquence nulle ($U_o$) est remplacée dans la comparaison par la différence de la valeur en temps réel et d'une valeur moyenne à long terme, par exemple les valeurs moyennes de celle-ci calculées sur les dernières 10 minutes.

$$\underline{Z}_f$$

$$\underline{U}_v \qquad \underline{U}_o \qquad \underline{Z}_o$$

Fig. 1

$$R_e \qquad 3C_e$$

Fig. 2a

$$L_e \qquad R_e \qquad 3C_e$$

Fig. 2b